# EUROPÄISCHE PATENTSCHRIFT

(11) **EP 1 192 659 B1**
(45) Veröffentlichungstag und Bekanntmachung des Hinweises auf die Patenterteilung: **27.08.2003**
(21) Anmeldenummer: 00945856.3
(22) Anmeldetag: 30.06.2000
(51) Int. Cl.: H01L 25/065, H01L 21/98

(54) **MULTI-CHIP-MODUL UND VERFAHREN ZUM HERSTELLEN EINES MULTI-CHIP-MODULS**
MULTICHIP MODULE AND METHOD FOR PRODUCING A MULTICHIP MODULE
MODULE MULTIPUCE ET SON PROCEDE DE PRODUCTION

(30) Priorität: 01.07.1999 EP 99112540; 07.03.2000 DE 10011005
(43) Veröffentlichungstag der Anmeldung: 03.04.2002
(73) Patentinhaber: Fraunhofer-Gesellschaft zur Förderung der angewandten Forschung e.V., 80636 München (DE)
(72) Erfinder: LANDESBERGER, Christof, D-81241 München (DE); REICHL, Herbert, D-14193 Berlin (DE); ANSORGE, Frank, D-81245 München (DE); RAMM, Peter, D-85276 Pfaffenhofen (DE); EHRMANN, Oswin, D-13505 Berlin (DE)
(74) Vertreter: Schoppe, Fritz, Dipl.-Ing.
(86) Internationale Anmeldenummer: EP0006132
(87) Internationale Veröffentlichungsnummer: WO01003189

(56) Entgegenhaltungen:
- EP-A- 0 304 263
- EP-A- 0 465 227
- EP-A- 0 920 058
- US-A- 5 793 115
- US-A- 5 841 193
- US-A- 6 025 995

## Beschreibung

Die vorliegende Erfindung bezieht sich auf integrierte Schaltungen und insbesondere auf dreidimensionale Multi-Chip-Module.

Chip-Systeme, die aus mehrere miteinander integrierten Einzelchips bestehen, werden allgemein als Multi-Chip-Module bezeichnet. Hierbei werden üblicherweise mehrere Chips auf ein Substrat gesetzt, das für alle Chips die Verdrahtungswege bereitstellt. Für die elektrischen Kontakte werden üblicherweise Drahtbondverbindungen und/oder Flip-Chip-Montagetechniken eingesetzt. Dieses zusammengesetzte Multi-Chip-Modul wird dann üblicherweise in ein vergleichsweise großes Gehäuse montiert, das Außenanschlüsse aufweist. Die Verdrahtung zwischen den inneren Anschlußflächen des Multi-Chip-Moduls und den äußeren Anschlußflächen werden dabei üblicherweise ebenfalls unter Verwendung von Bonddrähten realisiert.

Drahtbondverbindungen haben allgemein den Nachteil, daß sie nicht hochfrequenzfähig sind, da Bonddrähte bei hohen Frequenzen erheblichen Serieninduktivitäten darstellen und somit einen ausgeprägten Tiefpaßcharakter haben. Darüberhinaus ist das Drahtbonden insbesondere wenn viele Bonddrähte hergestellt werden müssen, außerordentlich zeitaufwendig und damit teuer.

Flip-Chip-Techniken mit Lotkugeln oder aber mit anisotrop leitfähigen Klebermaterialien erfordern hohe Prozeßtemperaturen, welche 200°C übersteigen können. Darüberhinaus sind relativ lange Zykluszeiten angezeigt. Durch die hohen Temperaturen werden ebenfalls unerwünscht hohe thermomechanische Spannungen im Chip-Verbund eingebaut. Schließlich sind Flip-Chip-Montagetechniken nicht zu mehrlagigen Chip-Stapeln erweiterbar. Die EP-A-0 920 058 zeigt ein Multi-Chip-Modul bestehend aus mehrlagigen Chip-Stopeln.

Ein weiterer wesentlicher Nachteil bei solchen Multi-Chip-Modulen ist die Tatsache, daß bereits im Schaltungsdesign des Substrats oder aber im Falle von mehrlagigen Chipstapeln im Schaltungsdesign der einzelnen Chips auf eine spätere dreidimensionale Integrationstechnik geachtet werden muß. Dies ist erforderlich, damit die geometrische Anordnung korrespondierender Anschlußflächen sichergestellt ist. Diese Voraussetzung ist besonders dann nachteilig, wenn das gesamte Multi-Chip-Modul eine sogenannte "Second-Source"-Anforderung erfüllen muß.

Der Grundgedanke von Multi-Chip-Modulen besteht darin, daß Chips, in denen verschiedene Funktionalitäten integriert sind, miteinander verdrahtet werden, um einen Chip eines Herstellers für eine bestimmte Funktion und einen Chip eines anderen Herstellers für eine andere Funktion verwenden zu können. Dieses Konzept ermöglicht den Rückgriff auf preisgünstig verfügbare Standardchips eines Herstellers oder aber verschiedener Hersteller. Damit ist es nicht mehr erforderlich, alle Funktionalitäten in einem einzigen Chip zu integrieren, was für vielerlei Anwendungen viel zu aufwendig ist.

Wenn an ein Multi-Chip-Modul gedacht wird, das eine Vielzahl von einzelnen Chips umfassen soll, ist jedoch die Abhängigkeit von den einzelnen Chip-Herstellern beachtlich. Ist nur ein einziger Chip von z. B. 10 Chips eines Multi-Chip-Moduls nicht mehr verfügbar, so muß bei bekannten Multi-Chip-Modulen, bei denen eine Basis sämtliche Verdrahtungswege und Kontaktanschlußflächen bereitstellt, völlig neu entworfen werden, um an die anderen Anschlußkontaktgeometrien eines Chips von einem anderen Hersteller angepaßt zu sein.

Derselbe Nachteil tritt ein, wenn festgestellt wird, daß ein Chip, der eine bestimmte Funktionalität implementiert, von einem Konkurrenzhersteller wesentlich günstiger produziert wird als von einem anderen Hersteller. Bei bekannten Multi-Chip-Modulen wurde daher oftmals der teuere Chip weiter eingebaut, um nicht ein komplett neues Schaltungsdesign durchführen zu müssen, dessen Preis den Preisvorteil des billigeren Chips bei weitem überstiegen hätte.

Die Second-Source-Anforderung besteht somit darin, für möglichst viele Anwendungen vorprozessierte Chips, die fertig erworben werden können, einsetzen zu können. Dies ermöglicht Unabhängigkeit von einem einzelnen Chiphersteller und ermöglicht auch Flexibilität, preisgünstigere Chips konkurrierender Chiphersteller auswählen zu können. So haben Untersuchungen gezeigt, daß beispielsweise bei einfachen Silizium-Schaltungschips bis zu 90% der Wertschöpfung des späteren Produkts im Bereich der Aufbau- und Verbindungstechniken liegen, aber nicht bei der Herstellung des Wafers, aus dem die einzelnen Chips durch Vereinzeln erzeugt werden können. Schließlich ermöglicht ein konsequentes Multi-Chip-Modul-Konzept, daß sich ein Schaltungsentwickler nicht mehr so sehr auf die einzelnen Funktionalitäten der verschiedenen Chips konzentrieren muß, sondern lediglich noch auf die Verschaltung der einzelnen Chipkomponenten untereinander.

Eine generelle Anforderung bei Multi-Chip-Modulen besteht ferner darin, ein Endprodukt zu erhalten, das ein kleines Volumen hat, und das darüberhinaus möglichst preisgünstig hergestellt werden kann, was wiederum bedeutet, daß keine aufwendigen neuen Herstellungsverfahren entwickelt werden müssen, sondern daß so weit als möglich auf bekannte Standardherstellungsprozesse zurückgegriffen werden kann.

Die Aufgabe der vorliegenden Erfindung besteht darin, ein Multi-Chip-Modul-Konzept zu schaffen, das zum einen flexibel ist und zum anderen preisgünstig realisierbar ist.

Diese Aufgabe wird durch ein Multi-Chip-Modul nach Patentanspruch 1 oder durch ein Verfahren zum Herstellen eines Multi-Chip-Moduls nach Patentanspruch 10 gelöst.

Der vorliegenden Erfindung liegt die Erkenntnis zugrunde, daß ein preisgünstiges und flexibles Multi-Chip-Modul-Konzept dadurch realisiert werden kann, daß auf einem Basis-Chip mit üblichen Dimensionen zumindest ein Top-Chip unter Verwendung einer Klebeschicht aufgebracht wird, wobei der Top-Chip ein dünner Chip ist, dessen Dicke kleiner als 100 µm ist. Es wird bevorzugt, Top-Chips einzusetzen, deren Dicke sogar kleiner als 50 µm ist und insbesondere im Bereich von 20 µm und darunter liegen kann.

Im Gegensatz zu bekannten Verfahren wird beim erfindungsgemäßen Multi-Chip-Modul-Konzept der dünne Top-Chip auf einem passiven Bereich des Basis-Chips aufgebracht, so daß der Basis-Chip und der Top-Chip unabhängig voneinander entworfen sein können und somit auch entsprechend der Second-Source-Anforderung beliebige ausgetauscht werden können, da keine geometrisch korrespondierenden Kontaktanschlußflächen vorhanden sein müssen. Aufgrund der Verwendung der superdünnen Chips ist es möglich, nach dem Aufkleben des Top-Chips auf den Basis-Chip den Chipverbund unter Verwendung einer Planarisierungsschicht zu planarisieren, um dann sämtliche Verbindungen zwischen dem Top-Chip und dem Basis-Chip und/oder von dem Top-Chip oder dem Basis-Chip nach außen über entsprechende Durchgangslöcher, welche mit leitfähigem Material gefüllt sind, durch die Planarisierungsschicht hindurch auszuführen.

Die Kontaktanschlußflächen sowohl des Basischips als auch des Top-Chips können somit über entsprechende Durchgangslöcher durch die Planarisierungsschicht gewissermaßen nach oben herausgeführt werden, um dann unter Verwendung einer üblichen Lithographietechnologie beliebige Kontaktstrukturen herzustellen, durch die der Top-Chip und der Basis-Chip miteinander verbunden werden können, oder durch die der Top-Chip für sich bzw. der Basis-Chip für sich von außen kontaktiert werden können.

Aufgrund der Tatsache, daß das Multi-Chip-Modul nach dem Planarisieren eine im wesentlichen planare Oberfläche hat, sind sämtliche für planare Oberflächen geeignete Prozeßtechnologieschritte einsetzbar. Andererseits ermöglicht der Einsatz der dünnen Top-Chips, daß Durchgangslöcher durch die Planarisierungsschicht mit begrenztem Aufwand hergestellt werden können und darüberhinaus zuverlässig mit Metall gefüllt werden können, um die Anschlußflächen nach oben herauszuführen. Da die Dicke der Top-Chips kleiner als 100 µm ist und bis zu unter 20 µm betragen kann, sind die Aspektverhältnisse der erforderlichen Durchgangslöcher derart, daß eine zuverlässige Prozessierung mit üblichen Prozeßtechnologien möglich ist.

Ein weiterer wesentlicher Vorteil ist die auftretende Volumenminimierung. Jeder zusätzlich aufgebrachte Chip trägt nur einen dünnen Film zum Bauelementevolumen bei. Das komplette Multi-Chip-Modul ist letztlich nicht größer als ein Standard-IC. Diese Eigenschaft führt zu einem weiteren Vorteil, der darin besteht, daß das Multi-Chip-Modul unter Verwendung sämtlicher bekannter Anschlußtechniken weiter verarbeitet werden kann, wie z. B. durch Flip-Chip-Technologien oder aber über Bonddrähte.

Ein weiterer Vorteil, der zu einer wesentlichen Preisreduzierung führt, besteht darin, daß alle Kontaktierungs- und Verdrahtungs-Prozeßschritte auf einem Basis-Wafer als Träger stattfinden, wobei der Basis-Chip ein Teil des Basis-Wafers ist. Ein Großteil der Aufbau- und Verbindungstechnik kann somit bereits in der Waferfabrik sehr kostengünstig gefertigt werden. Das arbeitsintensive und zeitintensive Bonden zwischen den Chips des Moduls selbst oder zwischen den Chips des Moduls und äußeren Anschlußflächen entfällt.

Schließlich sind die Prozesse der "Chip-Montage" und der "Chip-Kontaktierung" getrennt. Die Montage der einzelnen dünnen Top-Chips des MCM-Moduls erfolgt in einem einfachen und schnellen Bestückungsprozeß vorzugsweise bei Raumtemperatur. Das Verkleben, d. h. das Härten der Klebeschicht unterhalb der Top-Chips, erfolgt bei niedrigen Temperaturen zwischen 30 und 130°C. Es wird eine ganzflächige und homogene Verklebung erreicht. Die Trennung von Montage und Kontaktierung ermöglicht daher eine spannungsarme Aufbauweise, die zusätzlich wesentlich kleinere Taktzeiten mit sich bringt, als sie bei Flip-Chip-Techniken oder Drahtbondtechniken zu finden sind.

Die Technik zur Herstellung der Multi-Chip-Module kann ohne Zusatzaufwand zur Realisierung von mehrlagigen Chip-Verdrahtungsebenen erweitert werden.

Schließlich ist eine beliebige Auswahl der Chip-Komponenten möglich. Die Multi-Chip-Modul-Technik gemäß der vorliegenden Erfindung, bei der die gesamte Verdrahtung in der Planarisierungsschicht, also neben den Top-Chips stattfindet, ist tatsächlich unabhängig von den Einzel-Chip-Komponenten. Bereits existierende Schaltungswafer aus beliebiger Produktion können damit sofort dieser Integrationstechnik zugeführt werden, ohne daß die Schaltungswafer selbst wieder umentwickelt werden müssen.

Bevorzugte Ausführungsbeispiele der vorliegenden Erfindung werden nachfolgend bezugnehmend auf die beiliegenden Zeichnungen detailliert erläutert. Es zeigen:
- Fig. 1: ein Multi-Chip-Modul gemäß einem ersten Ausführungsbeispiel der vorliegenden Erfindung mit einer Bond-Anschlußfläche;
- Fig. 2: ein Multi-Chip-Modul gemäß einem weiteren Ausführungsbeispiel der vorliegenden Erfindung mit Lotkugeln für eine Flip-Chip-Montage; und
- Fig. 3: eine Draufsicht auf ein Multi-Chip-Modul gemäß der vorliegenden Erfindung mit zwei Top-Chips vor der Vereinzelung des Basis-Wafers, um die einzelnen Multi-Chip-Module zu erhalten.

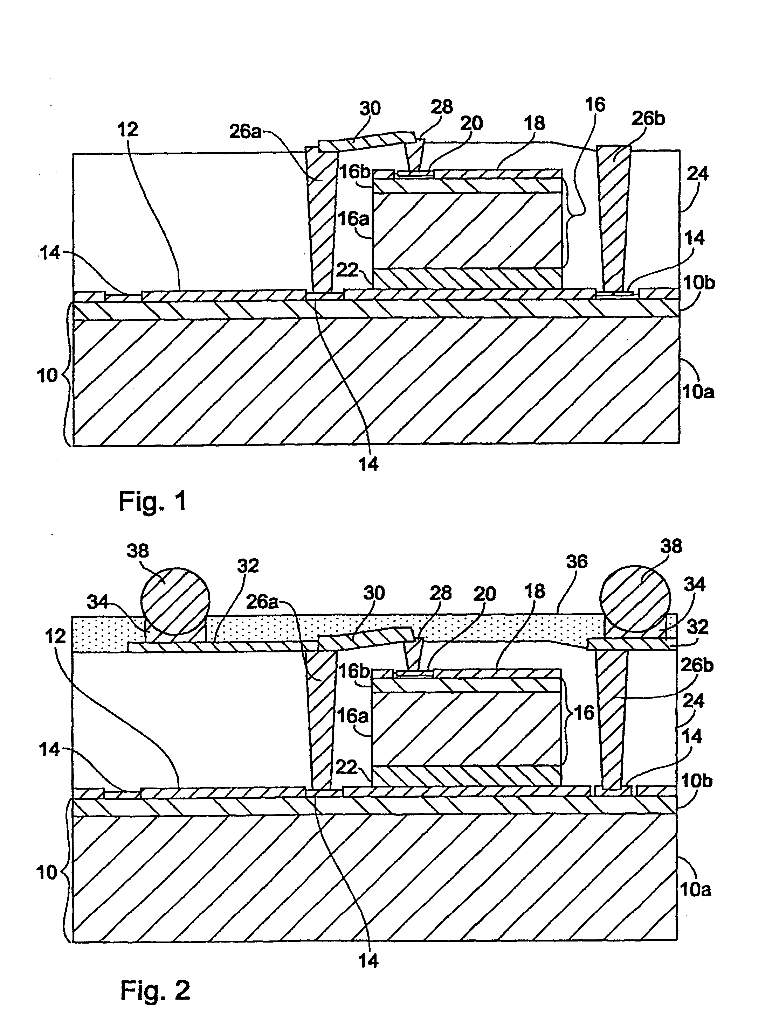

In Fig. 1 ist ein Multi-Chip-Modul gemäß einem ersten Ausführungsbeispiel der vorliegenden Erfindung gezeigt. Dasselbe umfaßt einen Basis-Chip 10, der ein Halbleitersubstrat 10a und einen aktiven Bereich 10b aufweist, wobei der aktive Bereich 10b bei dem bevorzugten Ausführungsbeispiel der vorliegenden Erfindung ein CMOS-Bereich ist. Auf der Oberfläche des Basis-Chips 10 ist eine Passivierungsschicht 12 aufgebracht, die von Anschlußflächen 14 durchbrochen ist, um den Basis-Chip 10 je nach Anwendung zu kontaktieren.

Das Multi-Chip-Modul, das in Fig. 1 gezeigt ist, umfaßt ferner einen Top-Chip 16, der ebenfalls ein Halbleiter-Substrat 16a und beim hier bevorzugten Ausführungsbeispiel einen CMOS-Bereich 16b umfaßt. Der Top-Chip 16 hat ferner an seiner Oberseite eine Passivierungsschicht 18, die über einer Anschlußfläche 20 durchbrochen ist. Der Top-Chip 16 ist über eine Klebeschicht 22 mit der Passivierungsschicht 12 des Basis-Chips verbunden, derart, daß der Top-Chip 16 und der Basis-Chip 10 über die Klebeschicht 22 mechanisch verbunden sind. Der Top-Chip 16 ist in einer elektrisch isolierenden Planarisierungsschicht 24 eingebettet. Die elektrisch isolierende Planarisierungsschicht 24 bedeckt die Bereiche der Passivierungsschicht 12, in denen der Top-Chip 16 nicht angeordnet ist. Die Planarisierungsschicht 24 erstreckt sich zunächst über alle Anschlußflächen des Basis-Chips 10.

Bei dem in Fig. 1 gezeigten Ausführungsbeispiel ist der Top-Chip 16 vollständig in die Planarisierungsschicht 24 eingebettet. Dies bedeutet, daß sich die Planarisierungsschicht 24 auch über den Top-Chip 16 hinweg erstreckt. Alternativ könnte die Planarisierungsschicht 24 jedoch auch derart ausgeführt sein, daß sie bündig zu der Passivierungsschicht 18 des Top-Chips ist, wobei in diesem Fall die Anschlußfläche 20 des Top-Chips unmittelbar freiliegen würde und nicht durch die Planarisierungsschicht 24 bedeckt wäre.

Zum Herausführen von zumindest einigen der Anschlußflächen 14 des Basis-Chips wird in der Planarisierungsschicht 24 eine Mehrzahl von Durchgangslöchern 26a, 26b gebildet, welche mit leitfähigem Material gefüllt sind.

Für den in Fig. 1 gezeichneten Fall, bei dem die Planarisierungsschicht 24 den Top-Chip 16 vollständig einbettet, wird ferner ein weiteres Durchgangsloch 28 gebildet, das sich jedoch nicht bis zum Basis-Chip erstreckt, sondern lediglich durch den oberhalb des Top-Chips vorhandenen Bereich der Planarisierungsschicht bis zur Anschlußfläche 20 des Top-Chips 16 erstreckt. Auch dieses Durchgangsloch 28 ist mit leitfähigem Material gebildet, um die Anschlußfläche 20 nach oben herauszuführen.

Um den Basis-Chip 10 mit dem Top-Chip 16 zu verdrahten, ist ferner eine Metallisierung 30 vorgesehen, die sich von dem mit elektrisch leitfähigem Material gefüllten Durchgangsloch 26a bis zu dem mit elektrisch leitfähigem Material gefüllten Durchgangsloch 28 erstreckt.

Für den Fall des mit elektrisch leitfähigem Material gefüllten Durchgangslochs 26b, das lediglich zur Kontaktierung des Basis-Chips 10 vorgesehen ist, ist eine Anschlußfläche für eine Kontaktierung in dem in Fig. 1 gezeigten Querschnitt nicht eingezeichnet.

Bei dem in Fig. 1 gezeigten Ausführungsbeispiel ist zu sehen, daß es nicht unbedingt erforderlich ist, daß der Top-Chip 16 vollständig in die Planarisierungsschicht 24 eingebettet ist, sondern daß sich die Metallisierung 30 im Falle einer bündigen Planarisierungsschicht auch direkt bis zu der Anschlußfläche 20 des Top-Chips 16 erstrecken könnte.

Fig. 2 zeigt ein Multi-Chip-Modul gemäß einem weiteren Ausführungsbeispiel der vorliegenden Erfindung, das nicht für eine Bond-Kontaktierung der Metallisierung 30 vorgesehen ist, sondern das eine Kontaktstruktur hat, die für eine Flip-Chip-Montage angepaßt ist. Hierzu ist ein weiterer Metallisierungsbereich 32 vorgesehen, der einerseits mit der Metallisierung 30, die die Durchgangslöcher 26a und 28 verbindet, elektrisch leitfähig verbunden ist, und der andererseits unter einem ebenfalls mit elektrisch leitfähigem Material gefüllten Durchgangsloch durch eine Isolationsschicht 36 mündet. Auf den mit elektrisch leitfähigem Material gefüllten weiteren Durchgangslöchern 34 sind dann für eine Flip-Chip-Montage Lotkugeln 38 angeordnet. Ansonsten unterscheidet sich das Multi-Chip-Modul gemäß dem in Fig. 2 gezeigten Ausführungsbeispiel nicht von dem in Fig. 1 gezeigten Multi-Chip-Modul.

Anhand des in Fig. 2 gezeigten weiteren Ausführungsbeispiels der vorliegenden Erfindung wird deutlich, daß ein erfindungsgemäßes Multi-Chip-Modul beim Unterbringen in ein Gehäuse bzw. beim Kontaktieren mit äußeren Anschlußflächen ganz genauso wie Einzel-ICs behandelt werden kann. Letztendlich ist auch die Höhe des gesamten Multi-Chip-Moduls aufgrund des sehr dünnen Top-Chips nicht wesentlich größer als die Höhe eines üblichen Einzel-IC. Hier sei darauf hingewiesen, daß die Fig. 1 und 2 bezüglich der Dicken des Basis-Chips und des Top-Chips nicht maßstabsgetreu gezeichnet sind. In der Tat haben übliche Basis-Chips eine Dicke von 680 bis 800 µm, während für den Top-Chip eine Dicke von etwa 20 µm bevorzugt wird. Dies bedeutet, daß die Dicke des Basis-Chips in der Tat etwa 35 mal so groß ist wie die Dicke des Top-Chips.

Ein Metallisierungsschema kann auch durch einen CSP-Prozeß (CSP = Chip Size Package) unter Verwendung einer lötbaren Metallschicht und einer Aufbringung von Löthöckern oder "Löt-Bumps" erzeugt werden.

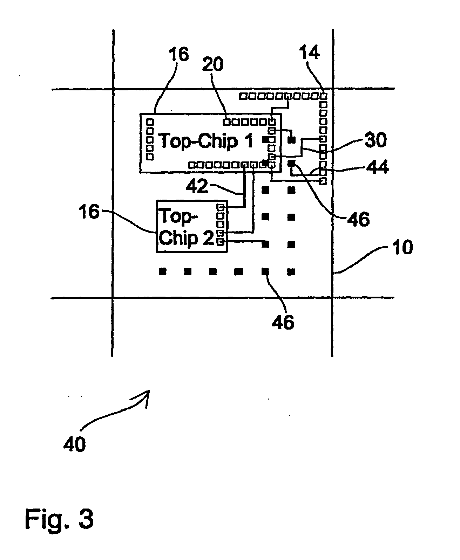

Fig. 3 zeigt eine Draufsicht auf einen Basiswafer 40, der durch eine Mehrzahl von Basis-Chips 10 gebildet sind. Fig. 3 zeigt also eine Mehrzahl von Multi-Chip-Modulen vor ihrer Vereinzelung in einzelne Multi-Chip-Module. Aus Übersichtlichkeitsgründen ist jedoch in Fig. 3 lediglich ein einziges Multi-Chip-Modul gezeigt, wobei jedoch in den zu dem Basischip 10 benachbarten Sektoren beliebige weitere Multi-Chip-Module vorhanden sein werden.

Fig. 3 zeigt ferner ein Multi-Chip-Modul, bei dem nicht nur ein Top-Chip vorhanden sind, sondern zwei Top-Chips. Die beiden Top-Chips sind über Inter-Chip-Kontaktstrukturen 42 miteinander verbunden. Der Top-Chip 1 ist ferner über eine Kontaktstruktur 30 mit Anschlußflächen 14 des Basis-Chips verbunden. Ferner ist in Fig. 3 anhand der Verdrahtungen 44 der Fall gezeigt, bei dem eine Anschlußfläche 14 des Basis-Chips direkt mit einer äußeren Anschlußfläche 46 des Multi-Chip-Moduls verbunden ist. Die Kontaktstruktur 44 von Fig. 3 umfaßt somit das weitere Durchgangsloch 26b von Fig. 1 sowie eine Metallisierung, die in Fig. 1 nicht dargestellt ist.

Im nachfolgenden wird auf die Herstellung der in Fig. 1 und Fig. 2 dargestellten erfindungsgemäßen MCM-Module eingegangen.

Das erfindungsgemäße Integrationskonzept macht sich die Verwendung von extrem dünnen Schaltungschips zu nutze, deren Restdicke bis zu 5 µm betragen kann. Mehrerer dieser extrem flachen Schaltungschips werden auf einem Basis-Wafer, wie z. B. dem Wafer 40 von Fig. 3, aufgeklebt. Die Klebeschicht 22 kann durch ein Spin-Coating-Verfahren sehr niedrig gehalten werden. Eine Kleberdicke von 3 µm kann bereits als ausreichend angesehen werden.

Vorzugsweise umfaßt ein Basis-Wafer 40, wie es ebenfalls in Fig. 3 gezeigt ist, eine Mehrzahl von Basis-Chips 10. Der mit den dünnen Top-Chips 16 bestückte Basis-Wafer wird nun vorzugsweise mit einem Polymermaterial, wie z. B. Polyimid, BCB (BCB = Benzocyclobuten) oder Spin-On Glass, in einem Spin-Coating-Verfahren beschichtet. Die dünnen Chips werden somit in den Polymerfilm, der die Planarisierungsschicht 24 bildet, vorzugsweise eingebettet.

Mittels eines Lithographie-Schritts und eines Standard-Ätzverfahrens werden dann die Durchgangslöcher 26a, 26b, 28 in dem Polymerfilm 24 erzeugt, welche jeweils auf den Metallisierungsebenen 20, 14 des Top-Chips 16 bzw. des Basis-Chips 10 enden. Die Durchgangslöcher werden dann beispielsweise mittels stromlosem Plattieren unter Verwendung von Nickel, durch galvanisches Abscheiden oder durch ein CVD-Verfahren mit Metall aufgefüllt. Außerdem wird eine ganzflächige Metallebene auf dem Wafer erzeugt, die auch als Dünnfilm-Metallisierung bezeichnet wird und vorzugsweise durch Sputtern gebildet wird.

Als Variante zum Sputtern können auch galvanisch erstellte Leiterbahnen verwendet werden, wenn eine größere Leiterbahndicke als sie durch Sputtern erreichbar ist, gewünscht wird.

In zumindest einem weiteren Lithographie-Prozeß wird dann diese oberste Metallebene strukturiert, um die Metallisierungen 30 bzw. 32 zu erhalten. Selbstverständlich können auch mehrere Metallisierungsebenen nacheinander gebildet werden, wenn zwischen den Metallisierungsebenen entsprechende Isolationsschichten 36 aufgebracht werden. Die Metallisierung 30 dient somit als Verdrahtungslage für die elektrischen Verbindungen zwischen den Chips, dem Basischip und den Kontakten des Multi-Chip-Moduls, die in Fig. 3 als ausgefüllte Vierecke dargestellt sind und mit dem Bezugszeichen 46 bezeichnet sind.

Durch die Verwendung der flachen Top-Chips 16 unterscheidet sich das fertige Multi-Chip-Modul von der äußeren Form her nicht von einem einzelnen Standard-IC mit einem einzigen Chip. Deshalb kann die elektrische Kontaktierung des MCM-Moduls mit externen Schaltungen und Bauteilen, wie z. B. einer Leiterplatte, mit jeder Standard-Verbindungstechnik erfolgen, wie z. B. durch Drahtbonden im Falle von Fig. 1 oder durch eine Flip-Chip-Montage im Falle von Fig. 2.

Den größten Nutzen im Hinblick auf die Minimierung der Gehäuseform und des Volumens des Chip-Systems wird durch einen Flip-Chip-Montageprozeß erreicht. Hierzu wird, wie es in Fig. 2 gezeigt ist, die Dünnfilmmetallisierungsebene 30 zur Umverdrahtung der elektrischen Kontakte verwendet. Durch die Umverdrahtung werden die normalerweise am Chiprand liegenden Kontakte über die gesamte Chip-Fläche verteilt. Die derart verteilten Anschlußflächen dienen nun als elektrische Kontakte für die Flip-Chip-Montage, nachdem die Lotkugeln 38 auf dieselben aufgebracht sind.

Im nachfolgenden wird auf einige Möglichkeiten zum Herstellen von Schaltungs-Chips eingegangen, deren Dicke kleiner als 100 µm ist, und deren Dicke bevorzugterweise im Bereich von 5 bis 40 µm liegt.

Um einen Schaltungs-Wafer mit einer Standarddicke von etwa 700 µm auf eine angestrebte Dicke von 5 bis 40 µm dünnen zu können, muß der Ausgangs-Wafer erst mit seiner aktiven Vorderseite auf ein Trägersubstrat, der ebenfalls ein Wafer aus Glas oder Silizium ist, geklebt werden. Wichtigste Voraussetzungen für diese Klebetechnik sind vollflächige lunkerfreie Verbindungen und eine Wiederlösbarkeit des Trägersubstrats. Als Materialien können Thermoplastmaterialien, d. h. Schmelzkleber, oder Klebefolien eingesetzt werden. Es wird derzeit bevorzugt, eine beidseitig haftende Klebefolie zu verwenden, die auf einer Seite eine spezielle Beschichtung hat, die nach einer Erwärmung auf eine Temperatur zwischen 90 und 140°C ihre Haftkraft verliert. Eine andere Möglichkeit besteht in der Verwendung von Klebefolien, die nach Bestrahlung mit UV-Licht ihre Haftkraft verlieren. Hierbei müssen Glaswafer als Trägersubstrate verwendet werden.

Nach dem Aufkleben des Schaltungswafers auf den Träger wird der Schaltungswafer von der Rückseite her gedünnt. Standardverfahren hierfür sind das Abschleifen oder das naßchemische Ätzen. Eine spezielle Variante des Dünn-Ätzens ist das Spin-Ätzen, bei dem der Wafer auf einem rotierenden Teller liegt, während von oben das Ätzmedium auf die Scheibe fließt und von dort abgeschleudert wird. Insbesondere durch die Kombination aus Schleifen und Ätzen können die Wafer bei Verwendung eines Trägersubstrats bis auf wenige Mikrometer Restdicke gedünnt werden.

Neben der Waferdünnung muß auch das Vereinzeln der dünnen Wafer in Chips gewährleistet sein. Ein Vereinzelungs-Verfahren ist das Sägen des dünnen Wafers, solange er noch auf dem Trägersubstrat fixiert ist. Sägt man durch den dünnen Wafer bis zur Klebeschicht, können die einzelnen dünnen Chips nach Überschreiten der Ablösebedingung von der Klebefolie abgenommen werden. Alternativ kann auch der dünne Wafer mitsamt dem Trägerwafer in Chips vereinzelt werden. Bei dieser Variante wird der dünne Chip mit dem Trägerchip plaziert und aufgeklebt. Der Trägerchip wird erst anschließend abgelöst.

Um Schaltungs-chips zu erhalten, die mechanisch möglichst integer sind, was zur Erhöhung der Ausbeute bei den hier verwendeten Dicken für die Top-Chips von Vorteil ist, kann ein Wafer, der vorprozessierte Top-Chips aufweist, auf der Oberseite beispielsweise durch Sägen oder durch Trockenätzen mit Gräben versehen werden. Nach dem Aufkleben dieses mit Gräben versehenen Wafers auf einer Klebefolie wird dann die Rückseite bis zu einem bestimmten Punkt naßchemisch geätzt, wonach das wesentlich schonendere aber auch langsamer dauernde Trockenätzen eingesetzt wird, um von der Rückseite her diesen Wafer so weit zu ätzen, bis die Gräben erreicht sind, wodurch eine chemische Vereinzelung des Wafers erreicht worden ist, um die einzelnen Top-Chips 16 zu erhalten. Falls auch die Gräben mittels Trockenätzen gebildet worden sind, haben die Top-Chips keine mechanischen Beschädigungen an ihren Kanten und können somit mit hoher Ausbeute hergestellt werden, um dann auf den Basis-Chips aufgeklebt zu werden.

Aus dem vorstehenden wird ersichtlich, daß das erfindungsgemäße Konzept sich besonders gut für Second-Source-Anforderungen eignet, da im Falle des Austausches eines einzelnen Chips des Multi-Chip-Moduls einfach ein Wafer mit anderen Chips entsprechender Funktionalität von einem anderen Lieferanten verwendet werden kann, der dann gedünnt wird, um die einzelnen Top-Chips zu erhalten. Erst dann wird wieder unter Verwendung üblicher lithographischer Oberflächenbearbeitungstechniken nach dem Aufkleben derselben und dem Aufbringen der Planarisierungsschicht die Verdrahtung für eine neue Einzel-Chip-Komponente angepaßt. Keine Veränderungen an anderen Basis-Chips oder Top-Chips sind nötig.

Erfindungsgemäße Multi-Chip-Module können als elektronische Bauteile und Systeme, welche einen extrem geringen Volumenbedarf erfordern, eingesetzt werden, wie z. B. bei mobilen tragbaren Telekommunikationssystemen oder medizinischen Überwachungs- und Hilfssystemen, welche beispielsweise Hörgeräte, Herzschrittmacher oder am Körper getragene Überwachungs- und Diagnosegeräte umfassen können. Ein weiterer Anwendungsbereich sind elektronische Bauteile, die für die elektrische Signalübertragung optimiert sind, wie z. B. Hochfrequenzbauelemente. Der besondere Nutzen bei der Verwendung der erfindungsgemäße MCM-Module ergibt sich insbesondere dadurch, daß auf Bonddrähte verzichtet werden kann, so daß die Verdrahtungslängen zwischen den verschiedenen Chips minimiert sind, und daß bei konsequenter Anwendung überhaupt keine Bonddrähte benötigt werden. Die elektrischen Verbindungswege können ferner in hochfrequenztauglichem Design, was die Leiterbreite und Leiterdicke anbetrifft, erstellt und gefertigt werden.

Das erfindungsgemäße MCM-Konzept ist schließlich auch dahingehend flexibel, daß Einzelkomponenten aus unterschiedlichen Grundmaterialien, wie z. B. Si, GaAs, InP, Quarz, usw., verwendet werden können, und daß auch Chips aus unterschiedlichen Fertigungstechnologien zusammengesetzt werden können. Dies ist z. B. der Fall bei Systemen aus Speicher-Chips, Logik-Chips, Sensorbauelementen, Chipkarten-Chips, Leistungsbauelementen oder Hochfrequenzübertragungschips (Transponder). Jedes Einzelelement kann in der für dasselbe kostengünstigsten Weise produziert werden, z. B. auch unter Verwendung unterschiedlicher Waferdurchmesser, wobei die volle Funktionalität erst im System des Multi-Chip-Moduls erreicht wird.

## Patentansprüche

1. Multi-Chip-Modul mit folgenden Merkmalen:
einem Basis-Chip (10), der auf einer Oberfläche eine Passivierungsschicht (12) und zumindest eine Anschlußfläche (14) aufweist;
einem Top-Chip mit einer Oberseite und einer Unterseite, wobei der Top-Chip (16) auf seiner Oberseite eine Passivierungsschicht (18) und zumindest eine Anschlußfläche (20) aufweist, und wobei die Dicke des Top-Chips kleiner als 100 µm ist;
einer Klebeschicht (22), die zwischen der Passivierungsschicht (12) des Basis-Chips (10) und der Unterseite des Top-Chips (16) angeordnet ist und den Top-Chip (16) und den Basis-Chip (10) mechanisch verbindet derart, daß die Anschlußfläche (14) von dem Top-Chip (16) nicht hedecht wird;
einer elektrisch isolierenden Planarisierungsschicht (24), die auf der Oberfläche des Basis-Chips (10) aufgebracht ist, und in der der Top-Chip (16) im wesentlichen eingebettet ist;
ein mit einem elektrisch leitfähigen Material gefülltes Durchgangsloch (26a) durch die Planarisierungsschicht (24), wobei das elektrisch leitfähige Material mit der Anschlußfläche (14) des Basis-Chips (10) in elektrisch leitfähiger Verbindung ist; und
einer Kontaktstruktur (28, 30) zum Verbinden des elektrisch leitfähigen Materials in dem Durchgangsloch (26a) mit der Anschlußfläche (20) des Top-Chips (16).

2. Multi-Chip-Modul nach Anspruch 1,
bei dem sich die Planarisierungsschicht (24) über die Oberfläche des Top-Chips (16) hinweg erstreckt; und
bei dem die Kontaktstruktur (28, 30) folgende Merkmale aufweist:
ein weiteres mit elektrisch leitfähigem Material gefülltes Durchgangsloch (28) durch die Planarisierungsschicht (24), wobei das elektrisch leitfähige Material mit der Anschlußfläche (20) des Top-Chips (16) elektrisch leitfähig verbunden ist; und
eine Metallisierung (30), die auf einer Oberfläche der Planarisierungsschicht (24) aufgebracht ist, die nicht in Verbindung mit der Oberfläche des Basis-Chips (10) ist, und die das eine (26a) mit einem elektrisch leitfähigen Material gefüllte Durchgangsloch mit dem weiteren (28) mit einem elektrisch leitfähigen Material gefüllten Durchgangsloch verbindet.

3. Multi-Chip-Modul nach Anspruch 1 oder 2, das ferner folgende Merkmale aufweist:
eine Umverdrahtungsstruktur (32), die auf der Oberfläche der Planarisierungsschicht (24) aufgebracht ist, die nicht in Verbindung mit der Oberfläche des Basis-Chips (10) ist, und die mit der Kontaktstruktur (30) in elektrisch leitfähiger Verbindung ist;
eine Isolationsschicht (36), wobei die Umverdrahtungsstruktur (32) zwischen der Isolationsschicht (36) und der Planarisierungsschicht (24) angeordnet ist; und
ein mit einem elektrisch leitfähigen Material gefülltes Anschluß-Durchgangsloch (34) durch die Isolationsschicht (36) zum Kontaktieren der Kontaktstruktur (28, 30).

4. Multi-Chip-Modul nach Anspruch 3, das ferner folgendes Merkmal aufweist:
ein Lotmaterial (38) auf dem mit elektrisch leitfähigem Material gefüllten Anschluß-Durchgangsloch (34) für eine Flip-Chip-Montage des Multi-Chip-Moduls auf einem Schaltungsträger.

5. Multi-Chip-Modul nach einem der vorhergehenden Ansprüche, bei dem die Klebeschicht (22) aus Epoxidharz ist und eine Dicke kleiner oder gleich 10 µm hat und vorzugsweise bis zu 3 µm dick ist.

6. Multi-Chip-Modul nach einem der vorhergehenden Ansprüche, bei dem die Planarisierungsschicht (24) aus einem Polymermaterial hergestellt ist.

7. Multi-Chip-Modul nach einem der vorhergehenden Ansprüche, das ferner folgende Merkmale aufweist:
eine erste Anschlußstruktur (44) zum Kontaktieren nur des Basis-Chips (10) und/oder eine zweite Anschlußstruktur (30) zum Kontaktieren lediglich des Top-Chips (16).

8. Multi-Chip-Modul nach einem der vorhergehenden Ansprüche, bei dem der Top-Chip und/oder der Basis-Chip eine CMOS-Schaltungsstruktur (16b, 10b) aufweisen.

9. Multi-Chip-Modul nach einem der vorhergehenden Ansprüche, das eine Zwischenlage aus einem dünnen Chip und einer Planarisierungsschicht zwischen dem Top-Chip und dem Basis-Chip aufweist, wobei eine Mehrzahl von weiteren Durchgangslöchern in der weiteren Planarisierungsschicht vorhanden ist, um den Chip der Zwischenlage mit dem Basischip und dem Top-Chip zu verbinden und/oder von außen zu kontaktieren.

10. Multi-Chip-Modul nach einem der vorhergehenden Ansprüche, bei dem das Material des Basis-Chips (10) zu dem Material des Top-Chips (16) unterschiedlich ist.

11. Verfahren zum Herstellen eines Multi-Chip-Moduls mit folgenden Merkmalen:
Bereitstellen eines Basis-Wafers (40) mit einem Basischip (10), der an einer Oberfläche eine Passivierungsschicht (12) und zumindest eine Anschlußfläche (14) aufweist;
Bereitstellen eines Top-Chips (16) mit einer Oberseite und einer Unterseite, wobei der Top-Chip (16) an seiner Oberseite eine Passivierungsschicht (18) und zumindest eine Anschlußfläche (20) aufweist, und wobei die Dicke des Top-Chips kleiner als 100 µm ist;
Aufbringen einer Klebeschicht (22) auf die Passivierungsschicht (12) des Basis-Chips (10);
Aufsetzen des Top-Chips (16) auf die Klebeschicht (22);
Planarisieren des Basis-Chips samt aufgeklebtem Top-Chip unter Verwendung einer Planarisierungsschicht (24);
Bilden eines Durchgangslochs (26a, 26b) durch die Planarisierungsschicht (24) zu der Anschlußfläche (14) des Basis-Chips (10);
Auffüllen des Durchgangslochs mit einem elektrisch leitfähigen Material; und
Kontaktieren des elektrisch leitfähigen Materials in dem Durchgangsloch (26a) mit der Anschlußfläche (20) des oberen Chips.

12. Verfahren nach Anspruch 11, bei dem der Schritt des Planarisierens ein Spin-Coating-Prozeß unter Verwendung eines Polymermaterials ist.

13. Verfahren nach Anspruch 11 oder 12, bei dem der Schritt des Auffüllens zumindest eines der folgenden Verfahren aufweist:
stromloses Plattieren, galvanisches Abscheiden oder CVD-Beschichten.

14. Verfahren nach einem der Ansprüche 11 bis 13, bei dem der Schritt des Kontaktierens folgende Merkmale aufweist:
Aufbringen einer Metallschicht auf die Planarisierungsschicht;
Strukturieren der Metallschicht unter Verwendung einer Lithographietechnik, um eine Metallisierung (30) zu erhalten.

15. Verfahren nach einem der Ansprüche 11 bis 14, bei dem der Schritt des Bereitstellens des Top-Chips (16) folgende Teilschritte aufweist:
Bereitstellen eines vorprozessierten Standard-Wafers;
Ätzen von Gräben in die Vorderseite des Wafers unter Verwendung eines Trockenätzverfahrens;
Aufbringen des Wafers auf einen Träger;
Abdünnen des Wafers von der Rückseite aus unter Verwendung eines Trockenätzens, bis die Gräben erreicht sind;
Lösen eines vereinzelten Chips von dem Träger, um einen Top-Chip (16) zu erhalten.

## Claims

1. A multichip module comprising:
base chip (10) having on one surface thereof a passivation layer (12) and at least one connecting area (14);
a top chip having an upper surface and a lower surface, said top chip (16) having on its upper surface a passivation layer (18) and at least one connecting area (20), the thickness of the top chip being less then 100 µm;
an adhesive layer (22) which is arranged between the passivation layer (12) of the base chip (10) and the lower surface of the top chip (16) and which mechanically interconnects the top chip (16) and the base chip (10) such that the connecting area (14) is not covered by the top chip (16);
an electrically insulating planarization layer (24) which is applied to the surface of the base chip (10) and into which the top chip (16) is substantially embedded;
a through-hole (26a) through the planarization layer (24), said through-hole (26a) being filled with an electrically conductive material and said electrically conductive material being in electrically conductive connection with the connecting area (14) of the base chip (10); and
a contact structure (28, 30) for connecting the electrically conductive material in said through-hole (26a) to the connecting area (20) of the top chip (16).

2. A multichip module according to claim 1,
in which the planarization layer (24) extends across the surface of the top chip (16); and
in which the contact structure (28, 30) comprises:
a further through-hole (28) through the planarization layer (24), said through-hole (28) being filled with an electrically conductive material and said electrically conductive material being connected in an electrically conductive manner to the connecting area (20) of the top chip (16); and
a metallization (30) applied to a surface of the planarization layer (24) which is not in connection with the surface of the base chip (10), said metallization (30) connecting said first through-hole (26a) filled with an electrically conductive material to said second through-hole (28) filled with an electrically conductive material.

3. A multichip module according to claim 1 or 2, said multichip module additionally comprising:
a re-wiring structure (32) applied to the surface of the planarization layer (24) which is not in connection with the surface of the base chip (10), said re-wiring structure (32) being in electrically conductive connection with the contact structure (30);
an insulating layer (36), the re-wiring structure (32) being arranged between the insulating layer (36) and the planarization layer (24); and
a contacting through-hole (34) through the insulating layer (36), said contacting through-hole (34) being filled with an electrically conductive material and used for contacting the contact structure (28, 30).

4. A multichip module according to claim 3, further comprising:
a solder material (38) on top of the contacting through-hole (34) filled with an electrically conductive material, said solder material (38) being used for flip-chip mounting of the multichip module on a circuit carrier.

5. A multichip module according to one of the preceding claims, wherein the adhesive layer (22) consists of epoxy resin and has a thickness which is smaller than or equal to 10 µm, said adhesive layer being preferably up to 3 µm thick.

6. A multichip module according to one of the preceding claims, wherein the planarization layer (24) is produced from a polymer material.

7. A multichip module according to one of the preceding claims, said multichip module further comprising:
a first contact structure (44) for contacting only the base chip (10) and/or a second contact structure (30) for contacting only the top chip (16).

8. A multichip module according to one of the preceding claims, wherein the top chip and/or the base chip comprise a CMOS circuit structure (16b, 10b).

9. A multichip module according to one of the preceding claims, comprising an intermediate layer composed of a thin chip and of a planarization layer between the top chip and the base chip, a plurality of additional through-holes being provided in said further planarization layer so as to connect the intermediate-layer chip to the base chip and the top chip and/or so as to contact said intermediate-layer chip from outside.

10. A multichip module according to one of the preceding claims, wherein the material of the base chip (10) is different from the material of the top chip (16).

11. A method for producing a multichip module comprising the following features:
providing a base wafer (40) including a base chip (10) having on one surface thereof a passivation layer (12) and at least one connecting area (14);
providing a top chip (16) having an upper surface and a lower surface, said top chip (16) having on the upper surface thereof a passivation layer (18) and at least one connecting area (20) and the thickness of the top chip being less then 100 µm;
applying an adhesive layer (22) to the passivation layer (12) of the base chip (10);
applying the top chip (16) to the adhesive layer (22);
planarizing the base chip together with the glued-on top chip making use of a planarization layer (24);
forming a through-hole (26a, 26b) which leads through the planarization layer (24) to the connecting area (14) of the base chip (10);
filling the through-hole with an electrically conductive material; and
contacting the electrically conductive material in said through-hole (26a) with the connecting area (20) of the upper chip.

12. A method according to claim 11, wherein the planarizing step is a spin-coating process in which a polymer material is used.

13. A method according to claim 11 or 12, wherein the filling step comprises at least one of the following methods:
electroless plating, electrodeposition or CVD coating.

14. A method according to one of the claims 11 to 13, wherein the contacting step comprises the following features:
applying a metal layer to the planarization layer;
patterning the metal layer making use of a lithographic technique so as to obtain a metallization (30).

15. A method according to one of the claims 11 to 14, wherein the step of providing the top chip (16) comprises the following sub-steps:
providing a pre-processed standard wafer;
etching of trenches in the upper surface of the wafer making use of a dry-etching process;
applying the wafer to a support;
thinning the wafer from the back, making use of a dry-etching process, until the trenches have been reached; detaching a diced chip from the support so as to obtain a top chip (16).

## Revendications

1. Module multipuce, aux caractéristiques suivantes :
une puce de base (10) présentant, sur une surface, une couche de passivation (12) et au moins une face de raaccordement (14) ;
une puce supérieure avec une face supérieure et une face inférieure, la puce supérieure (16) présentant, sur sa face supérieure, une couche de passivation (18) et au moins une face de raccordement (20) et l'épaisseur de la puce supérieure étant inférieure à 100 µm ;
une couche adhésive (22) disposée entre la couche de passivation (12) de la puce de base (10) et la face inférieure de la puce supérieure (16) et reliant mécaniquement la puce supérieure (16) et la puce de base (10), de sorte que la face de raccordement (14) ne soit pas recouverte par la puce supérieure (16);
une couche d'aplanissement isolante électriquement (24) appliquée sur la surface de la puce de base (10) et sensiblement enrobée dans la puce supérieure (16) ;
un trou de passage (26a), rempli d'un matériau électroconducteur, dans la couche d'aplanissement (24), le matériau électroconducteur se trouvant en communication de conduction électrique avec la face de raccordement (14) de la puce de base (10) ; et
une structure de contact (28, 30) destinée à relier le matériau électroconducteur dans le trou de passage (26a) à la surface de raccordement (20) de la puce supérieure (16).

2. Module multipuce selon la revendication 1,
dans lequel la couche d'aplanissement (24) s'étend au-delà de la surface de la puce supérieure (16) ; et
dans lequel la structure de contact (28, 30) présente les caractéristiques suivantes :
un autre trou de passage (28), rempli de matériau électroconducteur, dans la couche d'aplanissement (24), le matériau électroconducteur étant relié de manière électroconductrice à la face de raccordement (20) de la puce supérieure (16); et
une métallisation (30) appliquée sur une surface de la couche d'aplanissement (24) qui n'est pas en communication avec la surface de la puce de base (10) et qui relie l'un (26a) des trous de passage remplis de matériau électronducteur à l'autre (28) trou de passage rempli de matériau électronducteur.

3. Module multipuce selon la revendication 1 ou 2, présentant, par ailleurs, les caractéristiques suivantes :
une structure de recâblage (32) appliquée sur la surface de la couche d'aplanissement (24) qui n'est pas en communication avec la surface de la puce de base (10) et qui se trouve en communication de conduction électrique avec la structure de contact (30) ;
une couche isolante (36), la structure de recâblage (32) étant disposée entre la couche isolante (36) et la couche d'aplanissement (24) ; et
un trou de passage de raccordement (34), rempli de matériau électroconducteur, dans la couche isolante (36), destiné à la mise en contact de la structure de contact (28, 30).

4. Module multipuce selon la revendication 3, présentant, par ailleurs, la caractéristique suivante :
un matériau de brasage (38) sur le trou de passage de raccordement (34) rempli de matériau électroconducteur, en vue d'un montage puce retournée du module multipuce sur un porte-circuit.

5. Module multipuce selon l'une des revendications précédentes, dans lequel la couche adhésive (22) est réalisée en résine époxyde et a une épaisseur inférieure ou égale à 10 µm et, de préférence, de jusqu'à 3 µm.

6. Module multipuce selon l'une des revendications précédentes, dans lequel la couche d'aplanissement (24) est réalisée en un matériau polymère.

7. Module multipuce selon l'une des revendications précédentes, présentant, par ailleurs, les caractéristiques suivantes :
une première structure de raccordement (44), destinée à mettre en contact uniquement la puce de base (10), et/ou une seconde structure de raccordement (30), destinée à mettre en contact uniquement la puce supérieure (16).

8. Module multipuce selon l'une des revendications précédentes, dans lequel la puce supérieure et/ou la puce de base présentent une structure de circuit CMOS (16b, 10b).

9. Module multipuce selon l'une des revendications précédentes, présentant une couche intermédiaire consistant en une mince puce et une couche d'aplanissement entre la puce supérieure et la puce de base, une pluralité d'autres trous de passage étant présents dans l'autre couche d'aplanissement, pour relier la puce de la couche intermédiaire à la puce de base et à la puce supérieure et/ou pour la mettre en contact de l'extérieur.

10. Module multipuce selon l'une des revendications précédentes, dans lequel le matériau de la puce de base (10) est différent du matériau de la puce supérieure (16).

11. Procédé pour fabriquer un module multipuce, aux caractéristiques suivantes :
préparer une plaquette de base (40) avec une puce de base (10) présentant, sur une surface, une couche de passivation (12) et au moins une face de raccordement (14);
préparer une puce supérieure (16) avec une face supérieure et une face inférieure, la puce supérieure (16) présentant, sur sa face supérieure, une couche de passivation (18) et au moins une face de raccordement (20) et l'épaisseur de la puce supérieure étant inférieure à 100 µm ;
appliquer une couche adhésive (22) sur la couche de passivation (12) de la puce de base (10);
placer la puce supérieure (16) sur la couche adhésive (22);
aplanir la puce de base ensemble avec la puce supérieure y collée, à l'aide d'une couche d'aplanissement (24) ;
former un trou de passage (26a, 26b) dans la couche d'aplanissement (24), vers la face de raccordement (14) de la puce de base (10) ;
remplir le trou de passage d'un matériau électroconducteur ; et
mettre en contact le matériau électroconducteur dans le trou de passage (26a) avec la face de raccordement (20) de la puce supérieure.

12. Procédé selon la revendication 11, dans lequel l'étape d'aplanissement est une opération de revêtement au spin à l'aide d'un matériau polymère.

13. Procédé selon la revendication 11 ou 12, dans lequel l'étape de remplissage présente au moins l'un des procédés suivants :
placage sans courant, dépôt galvanique ou revêtement par DCV.

14. Procédé selon l'une des revendications 11 à 13, dans lequel l'étape de mise en contact présente les caractéristiques suivantes
appliquer une couche de métal sur la couche d'aplanissement ;
structurer la couche de métal à l'aide d'une technique lithographique, pour obtenir une métallisation (30).

15. Procédé selon l'une des revendications 11 à 14, dans lequel l'étape de préparation de la puce supérieure (16) présente les étapes partielles suivantes:
préparer une plaquette standard prétraitée ;
graver des fossés dans la face avant de la plaquette, à l'aide d'un procédé de gravure à sec ;
appliquer la plaquette sur un support ;
amincir la plaquette depuis la face arrière, à l'aide d'une gravure à sec, jusqu'à ce que soient atteints les fossés ;
détacher une puce individuelle du support, pour obtenir une puce supérieure (16).
